# EUROPEAN PATENT APPLICATION

(11) **EP 1 936 627 A1**
(43) Date of publication of application: **25.06.2008**
(21) Application number: 07123373.8
(22) Date of filing: 17.12.2007
(51) Int. Cl.: G11C 5/14, G11C 11/412, G11C 11/413

(54) **Reduction of power consumption of an integrated electronic system comprising distinct static random access storage resources**

(30) Priority: 22.12.2006 IT VA20060081
(71) Applicant: STMicroelectronics S.r.l., 20041 Agrate Brianza (Milano) (IT)
(72) Inventor: Torelli, Cosimo, 20060 Cassina De Pecchi (IT); Rimondi, Danilo, 24030 Mozzo (IT); Zappa, Rita, 20137 Milano (IT)
(74) Representative: Pellegri, Alberto

(57) **Abstract**

A monolithically integrated electronic system having a plurality of operating modes and comprising distinct random access static storage resources, acess to which is differently contemplated for different modes of operation, and means for interrupting power supply to distinct static storage resources that are not utilized in the currently selected operating mode, has two or more distinct static storage resources defined in distinct sectors of a single array of memory cells, each of which is separately powered through a dedicated supply line/source. All sectors share a single peripheral address and write/read circuitry that is also powered through a distinct supply line/source.

The on or off state of distinct sectors is determined via software and commanded by the running program of a certain application by the integrated electronic system.

A sector contemplated to remain always powered is composed by memory cells having a higher threshold of that of the memory cells of the other sectors of the array to be programmably switched off.

## Description

### FIELD OF THE INVENTION

This invention relates in general to integrated systems of large integration scale comprising distinct static random access storage resources.

### BACKGROUND OF THE INVENTION

In modem integrated systems, that is in complete functional systems integrated with large scale integration techniques (VLS) on a single monolithic silicon chip and generally referred to with the acronym SoC (System on Chip), static memories have the greatest static power consumption

Static power consumption is due to leakage currents of the basic devices and are strongly dependent on the size of the devices, on parameters of the fabrication process, particularly on the threshold voltage Vth, on dielectric thicknesses and obviously also on working temperature. In memory arrays, the leakage is particularly relevant because of the very large number of cells that may be smaller than the minimum size allowed by the used fabrication technology. Moreover, the number of static memories deployed in modem SoCs increases at each step forward of the fabrication technology.

In mobile applications such as for portable phones and alike and in the automotive field, it is necessary to limit as much as possible power consumption due to leakage without compromising the overall performances of the integrated system.

Besides the traditional integrated circuit technique known with the acronym RBB (Reverse Body Bias) and of devices with multiple supplies (of different voltages), the most effective way of limiting the current absorbed in stand-by state and under certain working conditions of the integrated system is to keep enabled only a small part of the static memory resources and to disable the remaining part.

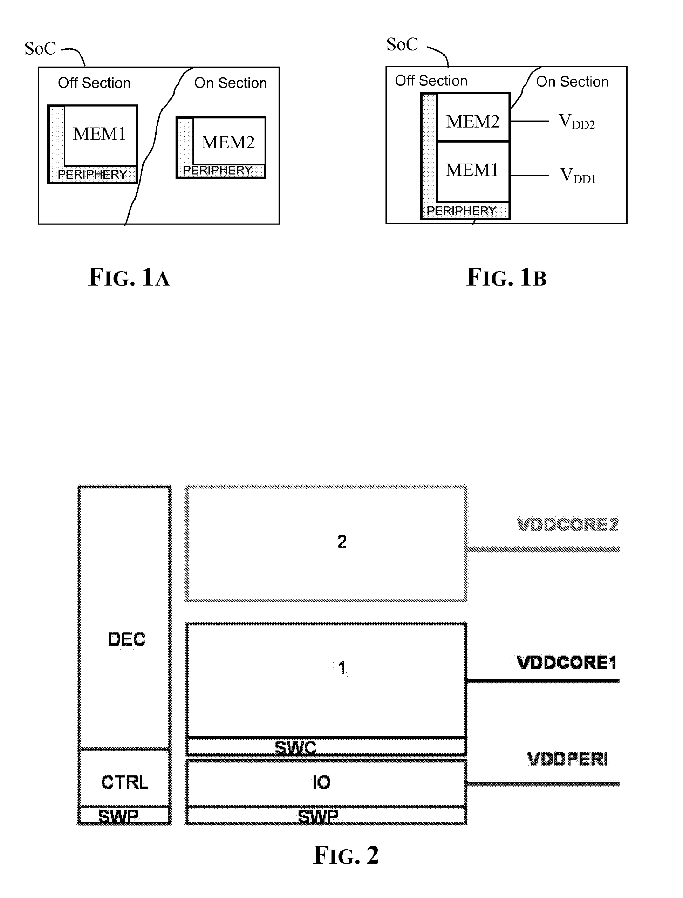

So far, the possibility of turning on and off the power supply to different static random access memory resources in a monolithically integrated system is achieved by using distinct memory blocks each of which is integrated in areas or sections of the device to which it is possible to independently interrupt the supply, as contemplated in the execution program of a particular application by the SoC. Such an organization of known SoCs is schematically depicted in Figure 1a.

There is an evident waste of silicon area. Moreover, designers must take into account the electrical effects caused by the turning off of certain logic circuitry used by a memory block to be disabled.

There is an evident need or usefulness of an architecture of the above mentioned capabilities that occupies a reduced integration area and that simplifies the realization of complex integrated electronic systems of reduced current consumption during stand-by phases and/or during the execution of applications that do not contemplate access to data stored in any or in some of distinct random access memories that are part of the integrated system.

### SUMMARY OF THE INVENTION

These desirable objectives are fully attained by the new architecture found by the applicants.

Basically, the gist of this invention that is outstandingly effective consists in realizing a single array or matrix of memory cells of total storage capacity comparable to the sum of the single storage capacities of two or more distinct random access memories for which a distinct management of turn off or turn on phases is contemplated in order to reduce static current absorption during particular functioning phases of the integrated system. Moreover, the peripheral circuitries, i.e. the logic circuits for decoding addresses of circuits for reading and writing data in and from addressed memory locations of the two or more sectors in which the array of cells is electrically subdivided, are unified.

The distinct sectors of the array of memory cells are individually supplied through respective supply lines connected to as many appropriate voltage supply sources through dedicated pins of the integrated device in case of controlled sources outside the device or to distinct controlled supply voltage sources present on the device. The present applicant found that this solution allows to reduce of about 5 to 15% the global area requirement, depending on the size of the distinctly powerable sectors of random access memory. This is primarily due to reductions of the overhead due to the peripheral circuitry that is substantially unified and to the simplification of electrical paths (reduction of the number of internal bias).

This invention is defined in the annexed claims.

### BRIEF DESCRIPTION OF THE DRAWINGS

**Figures 1a** and **1b** compare the known architecture of a monolithically integrated electronic system (SoC) according to the known technique and to this invention.
**Figure 2** is a block diagram of static memory resources in a monolithically integrated electronic system, according to an embodiment of this invention.
**Figure 3** is a block diagram according to an alternative embodiment of this invention that allows to program the number and the size of independently supplied sectors.

### DESCRIPTION OF EMBODIMENTS OF THE INVENTION

According to an embodiment of this invention, some or even all the distinct static random access memory resources that are defined in the design phase and that may be independently powered or disconnected as specifically commanded by the software during the execution of a certain application, by the integrated electronic system, consists in a SRAM architecture in which the array of cells is subdivided into two or more regions, in the depicted example MEM1 and MEM2, each of which is independently supplied through distinct dedicated supply lines V_{dd1} and V_{dd2}, as schematically illustrated in Figure 1b.

By comparing the architectures of Figure 1b with the prior architecture depicted in Figure 1a, it is noted that in the architecture of this invention the peripheral circuitries of the unified array of memory cells are coherently unified.

In the illustrated example, the sector 1 or primary sector may be a memory resource that must always be supplied for providing storage of sensible data even when the data are not being used, depending on the particular application, executed by the integrated system. Sector 2 or secondary sector, alike any other sector in which the single matrix of cells may be subdivided, represents a portion of the memory that on the contrary can be turned off during certain functioning phases of the device.

According to possible variation of the embodiments of the integrated device, the memory cells belonging to distinct sectors that may be independently powered or turned off, can be realized with threshold values that differ from a sector to the other. For example, the sector 1, if it is to be powered without interruptions, can be composed of cells with a relatively high threshold, while sector 2 can be composed of low threshold cells in order to speed up data processing.

The peripheral circuitry comprises address decoders, the circuitry for controlling and managing the various operations to be carried out in the distinctly allowable memory sectors. The input/output circuitry of data to be stored or read may have optionally and preferably, as illustrated in the shown example, a separate supply line even if, as an alternative, such a supply line may be in common with the supply of also an eventual primary sector 1 to be supplied without interruptions for storing essential data for carrying out the application.

In the example of Figure 2 are shown also the blocks SWC and SWP that represent optional devices for implementing the well known Reverse Body Bias (RBB) technique. These circuits realize a compression of the rail-to-rail supply voltage inside the memory array for reducing current leakage during stand-by phases when only the peripheral circuitry and the primary sector 1 must be kept on. If contemplated by the execution program of the particular application by the integrated electronic system, the peripheral circuitry and the primary sector may remain constantly powered.

The following table lists all possible configurations or functioning modes and the relative reduction effects on the stand-by current absorption.

| ***MODE*** | ***VDDC 1*** | ***VDDC2*** | ***VDDP*** | ***SWP*** | ***SWC*** | ***ISB REDUCTION*** | ***NOISE IMMUNITY*** |
|---|---|---|---|---|---|---|---|
| *1* | *VDD* | *GND* | *VDD* | *OFF* | *OFF* | + | ++ |
| *2* | *VDD* | *GND* | *GND* | *OFF* | *OFF* | +++ | ++ |
| *3* | *VDD* | *GND* | *VDD* | *ON* | *OFF* | ++ | ++ |
| *4* | *VDD* | *GND* | *VDD* | *ON* | *ON* | +++/+ | - |
| 5 | VDD | GND | GND | OFF | ON | ++++ | - |

The modes 1, 2 and 3 allow a reduction of the stand-by current without compressing the voltage levels of the memory cells. Current absorption may be further reduced in modes 4 and 5 at the cost of reducing noise rejection. In case the application being executed so permits, users may select modes 2 and 5 in which the unified peripheral circuitry of the distinct memory sectors is turned off.

The architecture of this invention allows also a higher degree of flexibility in defining the size of the primary memory sector and of secondary memory sectors or regions through a program operation.

In the tested sample embodiment, the monolithically integrated electronic system required first storage resources of 3kB and secondary storage resources of 5kB SRAM. In a low-leakage functioning mode of the device, the 5kB SRAM could be turned off while the 3kB SRAM kept uncorrupted sensible data for the application stored therein.

With the novel architecture of this invention depicted in Figure 2, it was possible to substitute two distinct integrated memories on the chip with a single 8kB array of cells, thus saving a significant amount of area because of the substantial unification of the peripheral circuitries and simplification of data routing.

In order to keep the possibility of carrying out ECC controls and to keep permanently driven the output buffers of the memory device, the peripheral circuitry may be kept turned on. This choice depends on the particular application to be carried out and on the amount of leakage that may be attributed to the peripheral circuitry.

In case the number and storage capacity of different secondary memory sectors, that may be turned on or off independently by the application program, are programmable, the array of memory cells may comprise a certain relatively large number of sectors that can be electrically supplied through distinct supply lines, such to determine a high "granularity" in terms of such numerous distinct memory portions. By programming, the most appropriate memory space subdivision for the particular application to be executed is established by the realization of the required number of secondary sectors of appropriate capacity each composed of a sufficient number of said granular portions that will be powered as a group of lesser capacity. The turning on and off of the so constituted distinct secondary sectors of appropriate storage capacity will in this case be operated on said grouped memory portions forming the independently powerable secondary sector for minimizing power consumption during different functioning phases of the device.

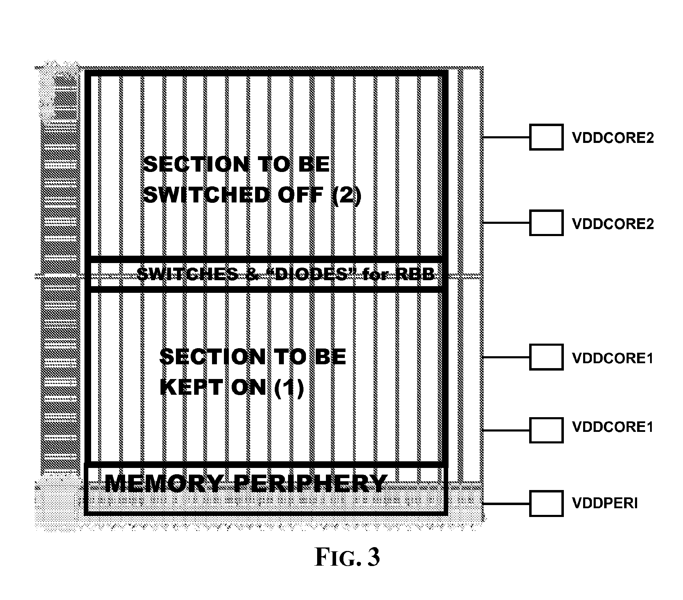

Figure 3 depicts schematically an embodiment that allows an improved distribution of the supply voltage to the distinct sectors through a plurality of distribution lines in order to enhance the equipotentiality and reducing voltage drops.

## Claims

1. A monolithically integrated electronic system having a plurality of functioning modes and comprising distinct static random access memory resources, the access to which is differently contemplated in various functioning modes, and means suitable for interrupting electrical supply to some of said distinct static memory resources that are not used in the current functioning mode, **characterized in that**
two or more of said distinct static memory resources are defined as sectors of a single array of memory cells, each of which is individually supplied through at least a controlled dedicated supply line, all the sectors sharing a same peripheral circuitry for addressing and reading/writing data also supplied through a dedicated supply line;
electrical supply of said distinct sectors being commanded by a program of execution of a certain application by the integrated electronic system.

2. The integrated electronic system of claim 1, wherein at least one of said sectors is expected to remain constantly supplied and the memory cells that compose it have larger thresholds than the thresholds of the memory cells that compose other sectors of the array for which programmed interruption of the supply is contemplated.

3. The system according to claim 1, **characterized in that** it comprises means (SWC, SWP) suitable for compressing the supply voltage applied to the memory cells of one or more of said distinct sectors of the array of memory cells and/or of said peripheral circuitry for reducing current leakage during certain phases of execution of the application by the integrated system.

4. The system according to claim 1, **characterized in that** said single array of memory cells is divided in a certain number of sectors having distinctly controlled supply lines, said sectors being programmably grouped to define said individually supplied sectors of desired storage capacity.
